# EUROPEAN PATENT SPECIFICATION

(11) **EP 3 123 527 B1**
(45) Date of publication and mention of the grant of the patent: **11.05.2022**
(21) Application number: 15770398.4
(22) Date of filing: 24.03.2015
(51) Int. Cl.: H01L 31/04, H01L 31/0256

(54) **SOLAR CELL WITH TRENCH-FREE EMITTER REGIONS**
SOLARZELLE MIT GRABENFREIEN EMITTERREGIONEN
CELLULE SOLAIRE AVEC RÉGIONS ÉMETTRICES SANS SILLONS

(30) Priority: 27.03.2014 US 201414227965
(43) Date of publication of application: 01.02.2017
(73) Proprietor: Maxeon Solar Pte. Ltd., Singapore 018981 (SG)
(72) Inventor: SMITH, David D., Campbell, California 95008 (US)
(74) Representative: Deambrogi, Edgardo
(86) International application number: PCT/US2015/022333
(87) International publication number: WO 2015/148570

(56) References cited:
- US-A1- 2007 151 599
- US-A1- 2009 308 438
- US-A1- 2010 081 264
- US-A1- 2011 104 618
- US-A1- 2011 201 188
- US-A1- 2012 073 650
- US-A1- 2012 138 135
- US-A1- 2012 266 951
- US-A1- 2012 322 199
- ROMER UDO ET AL: "Counterdoping with patterned ion implantation", 2013 IEEE 39TH PHOTOVOLTAIC SPECIALISTS CONFERENCE (PVSC), IEEE, 16 June 2013 (2013-06-16), pages 1280-1284, XP032568726, DOI: 10.1109/PVSC.2013.6744375
- Goetzberger A: "Photovoltaic Solar Energy Generation" In: "Optical Sciences", 1 January 2005 (2005-01-01), Springer, XP055777797, ISBN: 978-3-540-23676-4 pages 1-2,

## Description

### TECHNICAL FIELD

Embodiments of the present disclosure are in the field of renewable energy and, in particular, methods of fabricating solar cells having trench-free emitter regions, and the resulting solar cells.

### BACKGROUND

US 2012/322199 A1 relates to a patterned doping for poly silicon emitter solar cells. Photovoltaic cells, commonly known as solar cells, are well known devices for direct conversion of solar radiation into electrical energy. Generally, solar cells are fabricated on a semiconductor wafer or substrate using semiconductor processing techniques to form a p-n junction near a surface of the substrate. Solar radiation impinging on the surface of, and entering into, the substrate creates electron and hole pairs in the bulk of the substrate. The electron and hole pairs migrate to p-doped and n-doped regions in the substrate, thereby generating a voltage differential between the doped regions. The doped regions are connected to conductive regions on the solar cell to direct an electrical current from the cell to an external circuit coupled thereto.

Efficiency is an important characteristic of a solar cell as it is directly related to the capability of the solar cell to generate power. Likewise, efficiency in producing solar cells is directly related to the cost effectiveness of such solar cells. Accordingly, techniques for increasing the efficiency of solar cells, or techniques for increasing the efficiency in the manufacture of solar cells, are generally desirable. Some embodiments of the present disclosure allow for increased solar cell manufacture efficiency by providing novel processes for fabricating solar cell structures. Some embodiments of the present disclosure allow for increased solar cell efficiency by providing novel solar cell structures.

### SUMMARY OF THE INVENTION

A solar cell and method of fabricating a solar cell according to the invention are defined in the independent claims. Further advantageous embodiments are defined in the dependent claims.

### BRIEF DESCRIPTION OF THE DRAWINGS

Figures 1A-1E illustrate cross-sectional views of various stages in the fabrication of a solar cell, in accordance with an embodiment of the present disclosure, wherein:
Figure 1A illustrates a thin dielectric layer formed on a portion of a back surface of a substrate of a solar cell;
Figure 1B illustrates the structure of Figure 1A having a boron-containing silicon layer formed thereon;
Figure 1C illustrates the structure of Figure 1B having first regions, but not second regions, of the boron-containing silicon layer implanted with phosphorous ions;
Figure 1D illustrates the structure of Figure 1C heated to provide N-type polycrystalline silicon emitters and P-type polycrystalline silicon emitters; and
Figure 1E illustrates the structure of Figure 1D following formation of a plurality of conductive contact structures for the N-type polycrystalline silicon emitters and the P-type polycrystalline silicon emitters.
Figure 2 is a flowchart listing operations in a method of fabricating a solar cell as corresponding to Figures 1A-1E, in accordance with an embodiment of the present disclosure.
Figure 3A schematically illustrates a cross-sectional view of an inline platform for patterned implant involving a traveling wafer and stationary shadow mask, in accordance with an embodiment of the present disclosure.
Figure 3B illustrates an implant sequence through a graphite proximity mask in the apparatus of Figure 3A, in accordance with an embodiment of the present disclosure.
Figure 4 is a flowchart listing operations in another method of fabricating a solar cell, in accordance with an embodiment of the present disclosure.

### DETAILED DESCRIPTION

The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

This specification includes references to "one embodiment" or "an embodiment." The appearances of the phrases "in one embodiment" or "in an embodiment" do not necessarily refer to the same embodiment. Particular features, structures, or characteristics may be combined in any suitable manner consistent with this disclosure.

Terminology. The following paragraphs provide definitions and/or context for terms found in this disclosure (including the appended claims):

"Comprising." This term is open-ended. As used in the appended claims, this term does not foreclose additional structure or steps.

"Configured To." Various units or components may be described or claimed as "configured to" perform a task or tasks. In such contexts, "configured to" is used to connote structure by indicating that the units/components include structure that performs those task or tasks during operation. As such, the unit/component can be said to be configured to perform the task even when the specified unit/component is not currently operational (e.g., is not on/active). Reciting that a unit/circuit/component is "configured to" perform one or more tasks is expressly intended not to invoke 35 U.S.C. §112, sixth paragraph, for that unit/component.

"First," "Second," etc. As used herein, these terms are used as labels for nouns that they precede, and do not imply any type of ordering (e.g., spatial, temporal, logical, etc.). For example, reference to a "first" solar cell does not necessarily imply that this solar cell is the first solar cell in a sequence; instead the term "first" is used to differentiate this solar cell from another solar cell (e.g., a "second" solar cell).

"Coupled" - The following description refers to elements or nodes or features being "coupled" together. As used herein, unless expressly stated otherwise, "coupled" means that one element/node/feature is directly or indirectly joined to (or directly or indirectly communicates with) another element/node/feature, and not necessarily mechanically.

In addition, certain terminology may also be used in the following description for the purpose of reference only, and thus are not intended to be limiting. For example, terms such as "upper", "lower", "above", and "below" refer to directions in the drawings to which reference is made. Terms such as "front", "back", "rear", "side", "outboard", and "inboard" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Methods of fabricating solar cells having trench-free emitter regions, and the resulting solar cells, are described herein. In the following description, numerous specific details are set forth, such as specific process flow operations, in order to provide a thorough understanding of embodiments of the present disclosure. It will be apparent to one skilled in the art that embodiments of the present disclosure may be practiced without these specific details. In other instances, well-known fabrication techniques, such as lithography and patterning techniques, are not described in detail in order to not unnecessarily obscure embodiments of the present disclosure. Furthermore, it is to be understood that the various embodiments shown in the figures are illustrative representations and are not necessarily drawn to scale.

Disclosed herein are methods of fabricating solar cells. In one embodiment, a method of fabricating a solar cell involves forming a thin dielectric layer on a portion of a back surface of a substrate, the substrate having a light-receiving surface opposite the back surface. The method also involves forming a first polycrystalline silicon emitter region on a first portion of the thin dielectric layer and doped with an impurity of a first conductivity type. The method also involves forming a second polycrystalline silicon emitter region on a second portion of the thin dielectric layer proximate to the first polycrystalline silicon emitter region, the second polycrystalline silicon emitter region doped with an impurity of a second, opposite, conductivity type. A total concentration of the impurity of the first conductivity type in the first polycrystalline silicon emitter region is at least an order of magnitude greater than a total concentration of the impurity of the second conductivity type in the second polycrystalline silicon emitter region.

In another embodiment, a method of fabricating alternating N-type and P-type emitter regions of a solar cell involves forming a boron-containing silicon layer above a portion of a substrate by an in situ deposition process. The method also involves implanting first regions, but not second regions, of the boron-containing silicon layer with phosphorous ions to provide phosphorous-implanted regions of the boron-containing silicon layer. The method also involves heating to provide N-type polycrystalline silicon emitters in the first regions and to provide P-type polycrystalline silicon emitters in the second regions. The method also involves forming a plurality of conductive contact structures, each of the N-type polycrystalline silicon emitters and the P-type polycrystalline silicon emitters electrically connected to one of the plurality of conductive contact structures.

Also disclosed herein are solar cells. In one embodiment, a solar cell includes a substrate having a light-receiving surface and a back surface. A thin dielectric layer is disposed on a portion of the back surface of the substrate. A first polycrystalline silicon emitter region is disposed on a first portion of the thin dielectric layer and doped with an impurity of a first conductivity type. A second polycrystalline silicon emitter region is disposed on a second portion of the thin dielectric layer proximate to the first polycrystalline silicon emitter region disposed on the first portion of the thin dielectric layer. The second polycrystalline silicon emitter region is doped with an impurity of a second, opposite, conductivity type. A total concentration of the impurity of the first conductivity type in the first polycrystalline silicon emitter region is at least an order of magnitude greater than a total concentration of the impurity of the second conductivity type in the second polycrystalline silicon emitter region.

One or more embodiments described herein are directed to solar cells having emitter regions form above a substrate of the solar cell and, particularly, to such solar cells having a trench-free arrangement of the emitter regions. For reference, state-of-the-art solar cells having emitter regions formed in a polycrystalline silicon layer on a back surface of a back contact solar cell often have gaps separating N-type and P-type emitter regions. Furthermore, the gap is often extended to form a trench that extends into the underlying substrate. As such, such solar cells can be referred to as trench-contact solar cells. By contrast, one or more embodiments described herein are directed to solar cell process flows that that provide trench-free arrangements in a simplified manner by using ion implantation.

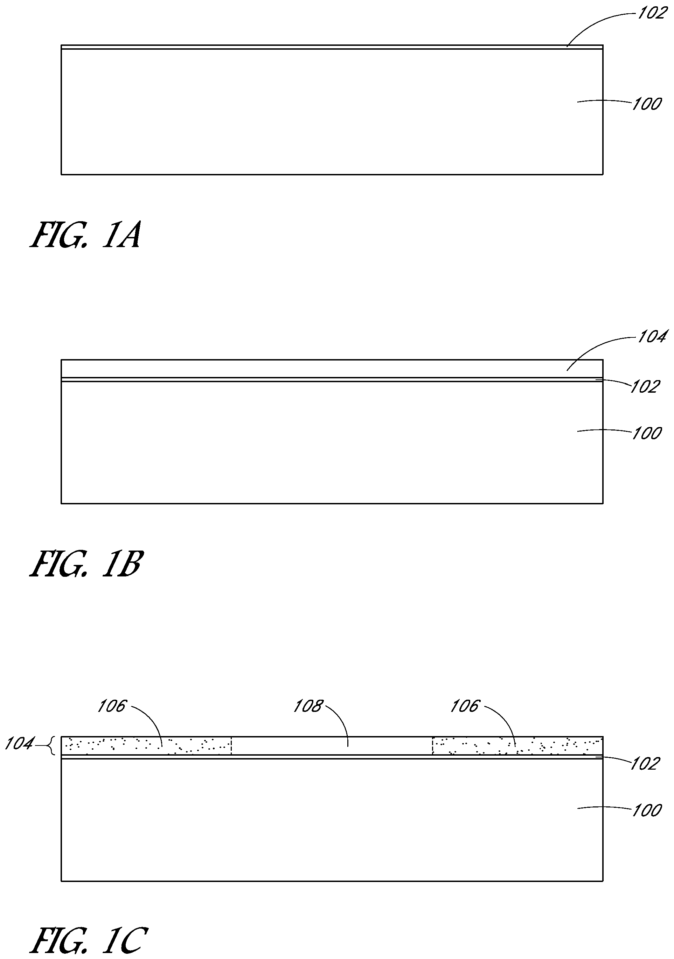

In accordance with general embodiments of the present disclosure, processes are described based on the discovery that light boron doping in a P-type polycrystalline silicon "finger" may be essential for eliminating space charge recombination in a trench-free back contact solar cell. In an embodiment not part of the invention, since a lowering of the respective N-type polycrystalline silicon doping concentration may not be necessary, a low level boron-doped region is formed in both P-type and N-type fingers, setting the P-type fingers at a concentration of approximately 1e19 cm⁻³ boron. Meanwhile, the low level boron doping is counter-doped in the N-type regions with phosphorous at a concentration of approximately 1e20 cm⁻³ to provide the N-type fingers. As described in association with Figures 1A-1E below, one implementation may involve initial formation of a plasma-generated P+ doped silicon layer followed by a shadow masked implant of phosphorous to convert regions of the P+ doped silicon layer to N-type fingers or dots. A thermal operation may be performed similar to activate the dopants, crystallize the emitter regions and, possibly, passivate the front surface of the solar cell.

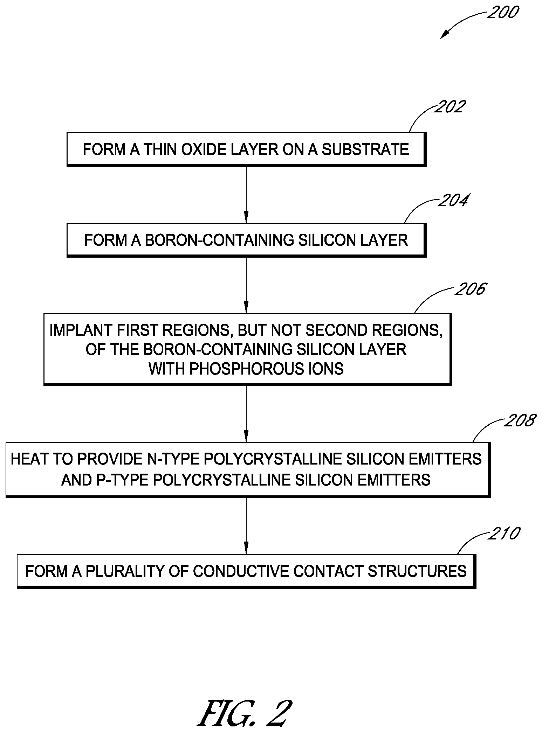

In accordance with an exemplary embodiment, a method of fabricating a solar cell involving fabricating alternating N-type and P-type emitter regions of the solar cell is disclosed. Figures 1A-1E illustrate cross-sectional views of various stages in the fabrication of a solar cell, in accordance with an embodiment of the present disclosure. Figure 2 is a flowchart 200 listing operations in a method of fabricating a solar cell as corresponding to Figures 1A-1E, in accordance with an embodiment of the present disclosure.

Referring to Figure 1A, and to corresponding operation 202 of flowchart 200, a thin dielectric layer 102 is formed on a portion of a back surface of a substrate 100 of a solar cell.

In an embodiment, the substrate 100 is a monocrystalline silicon substrate, such as a bulk single crystalline N-type doped silicon substrate. It is to be appreciated, however, that substrate 100 may be a layer, such as a multi-crystalline silicon layer, disposed on a global solar cell substrate. In an embodiment, the thin dielectric layer 102 is a tunneling silicon oxide layer having a thickness of approximately 2 nanometers or less.

Referring to Figure 1B, and to corresponding operation 204 of flowchart 200, a boron-containing silicon layer 104 is formed on the thin dielectric layer 102.

In an embodiment, the boron-containing silicon layer 104 forming a boron-containing silicon layer above a portion of a substrate by an in situ deposition process where the boron impurity is incorporated into the silicon layer at the time of formation of the silicon layer. In one such embodiment, forming the boron-containing silicon layer 104 involves forming a boron-containing amorphous silicon layer. In another such embodiment, forming the boron-containing silicon layer 104 involves forming a boron-doped polycrystalline silicon layer. In the former embodiment, the boron-containing amorphous silicon layer is a boron-containing hydrogenated silicon layer formed using plasma enhanced chemical vapor deposition (PECVD), represented by boron-doped a-Si:H, which includes S-H covalent bonds throughout the layer. Other forms of CVD may also be applicable such as atmospheric CVD or low pressure CVD. In the latter embodiment, the boron-doped polycrystalline silicon layer is formed using a PECVD process. It is to be appreciated that in other embodiments, the boron impurity may be incorporated into a silicon layer following formation of the silicon layer, e.g., by a global implant process.

Referring to Figure 1C, and to corresponding operation 206 of flowchart 200, first regions 106, but not second regions 108, of the boron-containing silicon layer 104 are implanted with phosphorous ions.

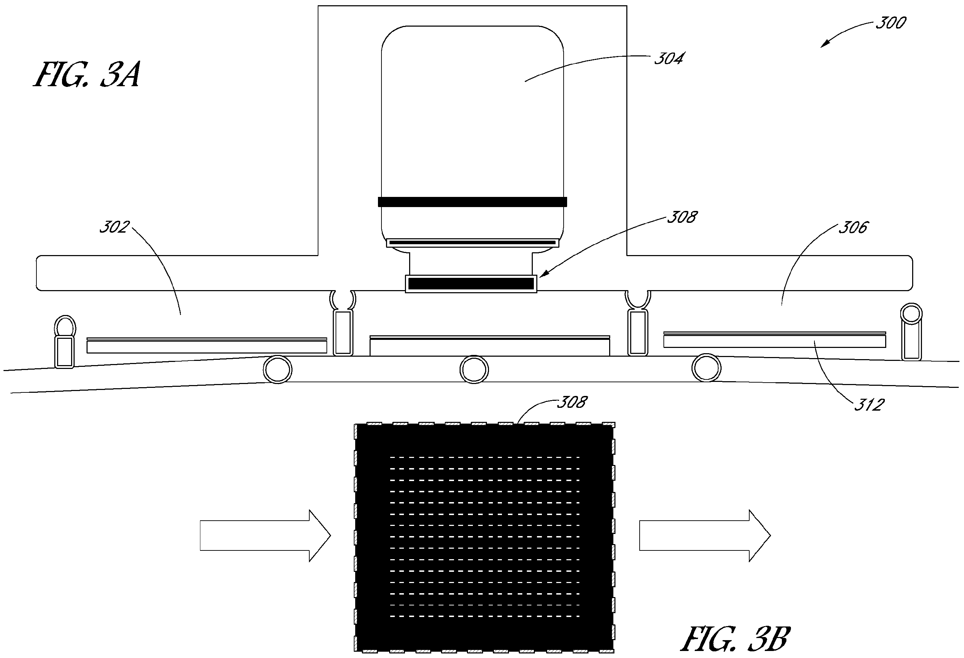

In an embodiment, the first regions 106 are implanted to provide phosphorous-implanted regions 106 of the boron-containing silicon layer 104 where the concentration of the phosphorous impurity of the phosphorous-implanted regions 106 is at least 10-fold (i.e., at least one order of magnitude) greater than the concentration of boron impurity in the regions 106 and, hence, at least one order of magnitude greater than the concentration of boron impurity in the non-phosphorous-implanted regions 108. In one embodiment, implanting the boron-containing silicon layer 104 with phosphorous ions involves implanting through a shadow mask, an exemplary process tooling for which is described below in association with Figures 3A and 3B. In a specific such embodiment, the implanting is performed through a graphite shadow mask positioned off of, but in close proximity to, the boron-containing silicon layer 104. In another specific embodiment, the implanting is performed through a silicon shadow mask positioned on the boron-containing silicon layer 104. In an embodiment, the implanting is performed by using ion beam implantation or plasma immersion implantation. It is to be appreciated that some residual doping of the second regions may actually occur, e.g., through scatter or imperfect doping. However, any such residual doping is not sufficient to counter-dope the second regions 108.

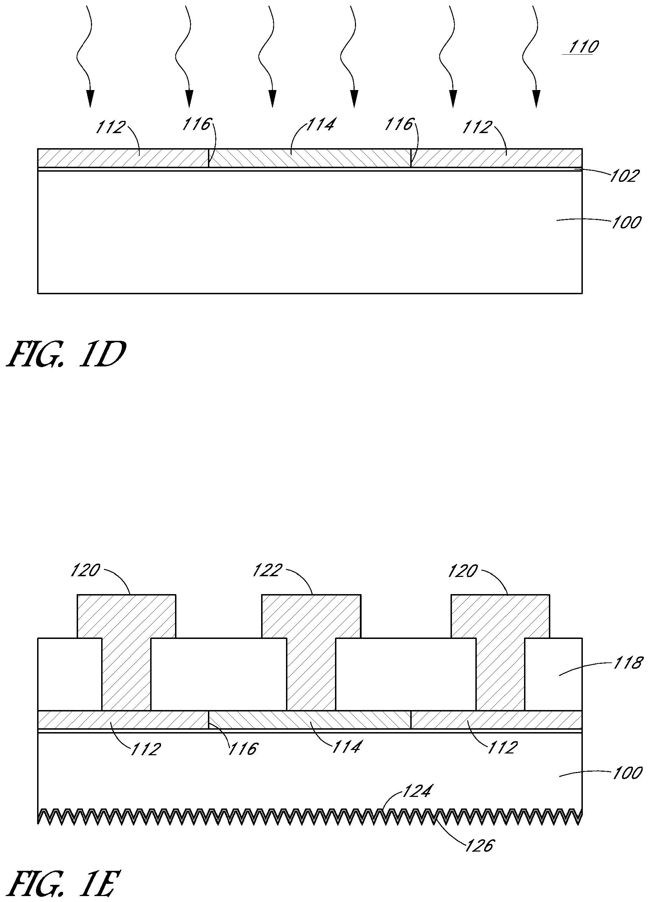

Referring to Figure 1D, and to corresponding operation 208 of flowchart 200, the structure of Figure 1C is heated 110 to provide N-type polycrystalline silicon emitters 112 and P-type polycrystalline silicon emitters 114.

In an embodiment, the heating is an annealing process, such as a rapid thermal annealing process, used to activate the impurities in the first and second regions 106 and 108, respectively, of the boron-containing silicon layer 104. In one embodiment, the annealing is performed at a temperature approximately in the range of 850 - 1100 degrees Celsius for a duration approximately in the range of 1 - 100 minutes. In one embodiment, the boron-containing silicon layer 104 is a boron-containing amorphous silicon layer, and the heating 110 involves crystallizing the boron-containing amorphous silicon layer to form boron-doped polycrystalline silicon in addition to activating the impurities. In another embodiment, the boron-containing silicon layer 104 is a boron-doped polycrystalline silicon layer, and the heating 110 involves at least activating the phosphorous impurity of the phosphorous-implanted regions to form phosphorous-doped regions. In an embodiment, a light phosphorous dopant drive is performed during the heating or annealing.

Thus, first polycrystalline silicon emitter regions 112 are formed on a first portion of the thin dielectric layer 102 and are doped with an N-type impurity. Second polycrystalline silicon emitter regions 114 are formed on a second portion of the thin dielectric layer 102, proximate to the first polycrystalline silicon emitter regions 112. The second polycrystalline silicon emitter regions 114 are doped with a P-type impurity. In one such embodiment, a total concentration of the activated N-type impurity in the first polycrystalline silicon emitter regions 112 is at least an order of magnitude greater than a total concentration of the activated P-type impurity in the second polycrystalline silicon emitter regions 114 and, hence, at least an order of magnitude greater than a total concentration of the activated P-type impurity in the first polycrystalline silicon emitter regions 112. Referring again to Figure 1D, the heating 110 involves forming a P/N junction 116 between adjacent ones of the N-type polycrystalline silicon emitters 112 and P-type polycrystalline silicon emitters 114.

Referring to Figure IE, and to corresponding operation 210 of flowchart 200, the structure of a plurality of conductive contact structures 120/122 is formed for the N-type polycrystalline silicon emitters (corresponding to contact structure 120) and the P-type polycrystalline silicon emitters (corresponding to contact structures 122).

In an embodiment, the conductive contact structures 120/122 are fabricated by first depositing and patterning an insulating layer 118 to have openings and then forming one or more conductive layers in the openings. In one such embodiment, the openings are formed by laser ablation. In an embodiment, the conductive contact structures 120/122 include metal and are formed by a deposition, lithographic, and etch approach or, alternatively, a printing or plating process or, alternatively, a foil adhesion process.

Referring again to Figure IE, a light-receiving surface 124, i.e., the surface opposite the surface on which the conductive contact structures are formed, is a texturized light-receiving surface. In one embodiment, a hydroxide-based wet etchant is employed to texturize the front surface of the substrate 102. It is to be appreciated that the timing of the texturizing of the light receiving surface may vary. For example, the texturizing may be performed before or after the formation of the thin dielectric layer 102 but, in one embodiment, prior to the formation of the boron-containing silicon layer 104. In an embodiment, a texturized surface may be one which has a regular or an irregular shaped surface for scattering incoming light, decreasing the amount of light reflected off of the light-receiving surfaces of the solar cell. Referring again to Figure 1E, additional embodiments can include formation of a passivation and/or anti-reflective coating (ARC) layers (shown collectively as layer 126) on the light-receiving surface 124, such as silicon nitride, silicon, silicon oxide or silicon oxynitride layers. It is to be appreciated that the timing of the formation of passivation and/or ARC layers may also vary.

Referring again to Figure IE, then, in an embodiment, a solar cell includes a substrate 100 having a light-receiving surface 124 and a back surface opposite the light-receiving surface. A thin dielectric layer 102 is disposed on a portion of the back surface of the substrate 100. A first polycrystalline silicon emitter region 112 is disposed on a first portion of the thin dielectric layer 102 and doped with an impurity of a first conductivity type. A second polycrystalline silicon emitter region 114 is disposed on a second portion of the thin dielectric layer 102 proximate to the first polycrystalline silicon emitter region 112 disposed on the first portion of the thin dielectric layer 102. The second polycrystalline silicon emitter region 114 is doped with an impurity of a second, opposite, conductivity type. A total concentration of the impurity of the first conductivity type in the first polycrystalline silicon emitter region 112 is at least an order of magnitude greater than a total concentration of the impurity of the second conductivity type in the second polycrystalline silicon emitter region 114. A first conductive contact structure 120 is electrically connected to the first polycrystalline silicon emitter region 112. A second conductive contact structure 122 is electrically connected to the second polycrystalline silicon emitter region 114. In one embodiment the solar cell is a back contact solar cell.

In one embodiment, the solar cell further includes a P/N junction 116 between the first polycrystalline silicon emitter region 112 and the second polycrystalline silicon emitter region 114. In one embodiment, the impurity of the first conductivity type in the first polycrystalline silicon emitter region 112 is an N-type impurity, and the impurity of the second conductivity type in the second polycrystalline silicon emitter region 114 is a P-type impurity. In a specific such embodiment, the N-type impurity is phosphorous and the total concentration of the impurity of the first conductivity type in the first polycrystalline silicon emitter region 112 is approximately 1E20 atoms/cm³. In that embodiment, the P-type impurity is boron and the total concentration of the impurity of the second conductivity type in the second polycrystalline silicon emitter region 114 is approximately 1E18 atoms/cm³.

Based on the nature of the fabrication scheme, in one embodiment, the first polycrystalline silicon emitter region 112 further includes the impurity of the second conductivity type. In a specific such embodiment, the total concentration of the impurity of the first conductivity type in the first polycrystalline silicon emitter region 112 is approximately two orders of magnitude greater than the total concentration of the impurity of the second conductivity type in the second polycrystalline silicon emitter region 114 and in the first polycrystalline silicon emitter region 112. In an embodiment, the counter-doped regions are at least an order of magnitude greater in doping concentration in order to sufficiently overwhelm (counter-dope) the first included dopant to dominate the doping characteristic. However, in that embodiment, the counter-doped regions are no more than approximately two orders of magnitude greater in doping concentrations such that conductivity differences of counter-doped versus non-counter-doped regions does not impact ultimate performance and efficiency of the solar cell.

In another aspect, as described briefly above, a shadow mask is used to direct the phosphorous implanting described in association with Figure 1C. In one such embodiment, a stationary graphite shadow mask is used for implantation. As an example, Figure 3A schematically illustrates a cross-sectional view of an inline platform for patterned implant involving a traveling wafer and a stationary shadow mask, in accordance with an embodiment of the present disclosure. Figure 3B illustrates an implant sequence through graphite proximity masks in the apparatus of Figure 3A, in accordance with an embodiment of the present disclosure. Referring to Figure 3A, an inline platform 300 includes a wafer input region 302, an implant source 304 (e.g., ion implantation or plasma immersion), and an output region 306. A stationary stencil mask 308, such as a stationary graphite mask, is held in proximity to, but not in contact with, a substrate 310 to provide an implanted substrate 312. In another embodiment, a silicon shadow mask, which may contact the substrate 312, may be used for implantation.

Overall, although certain materials are described specifically above, some materials may be readily substituted with others with other such embodiments remaining within the scope of the claims. For example, in an embodiment, a different material substrate, such as a group III-V material substrate, can be used instead of a silicon substrate. Furthermore, it is to be understood that, where N+ and P+ type doping is described specifically, other embodiments contemplated include the opposite conductivity type, e.g., P+ and N+ type doping, respectively. Additionally, although reference is made significantly to back contact solar cell arrangements, it is to be appreciated that approaches described herein may have application to front contact solar cells as well. In other embodiments, the so-called trench-free process described above may be implemented to ultimately fabricate trench-contact solar cells. For example, a process flow such as described above may first be implemented, and trenches may subsequently be formed between the emitter regions.

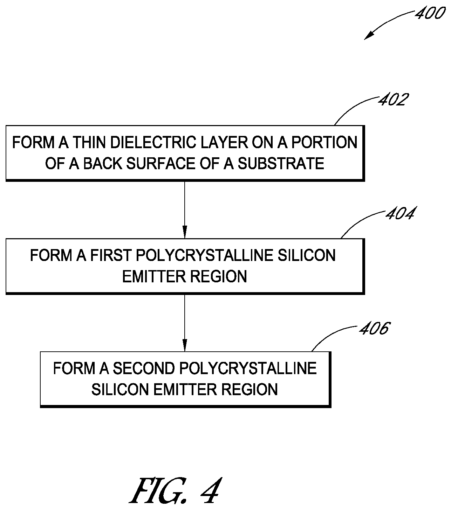

Thus, methods of fabricating solar cells having trench-free emitter regions, and the resulting solar cells, have been disclosed. As a general representative approach, Figure 4 is a flowchart 400 listing operations in another method of fabricating a solar cell, in accordance with an embodiment of the present disclosure. Referring to flowchart 400 of Figure 4, a method of fabricating alternating N-type and P-type emitter regions of a solar cell involves, at operation 402, forming a thin dielectric layer on a portion of a back surface of a substrate. The method also involves, at operation 404, forming a first polycrystalline silicon emitter region on a first portion of the thin dielectric layer. The method also involves, at operation 406, forming a second polycrystalline silicon emitter region on a second portion of the thin dielectric layer proximate to the first polycrystalline silicon emitter region. In one embodiment, a total concentration of an impurity of a first conductivity type in the first polycrystalline silicon emitter region is at least an order of magnitude greater than a total concentration of an impurity of a second, opposite, conductivity type in the second polycrystalline silicon emitter region.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of this disclosure.

The scope of the present disclosure includes any feature or combination of features disclosed herein (either explicitly or implicitly), or any generalization thereof, whether or not it mitigates any or all of the problems addressed herein. Accordingly, new claims may be formulated during prosecution of this application (or an application claiming priority thereto) to any such combination of features. In particular, with reference to the appended claims, features from dependent claims may be combined with those of the independent claims and features from respective independent claims may be combined in any appropriate manner and not merely in the specific combinations enumerated in the appended claims.

In an embodiment, a solar cell includes a substrate having a light-receiving surface and a back surface. A thin dielectric layer is disposed on a portion of the back surface of the substrate. A first polycrystalline silicon emitter region is disposed on a first portion of the thin dielectric layer and doped with an impurity of a first conductivity type. A second polycrystalline silicon emitter region is disposed on a second portion of the thin dielectric layer proximate to the first polycrystalline silicon emitter region disposed on the first portion of the thin dielectric layer. The second polycrystalline silicon emitter region is doped with an impurity of a second, opposite, conductivity type. A total concentration of the impurity of the first conductivity type in the first polycrystalline silicon emitter region is at least an order of magnitude greater than a total concentration of the impurity of the second conductivity type in the second polycrystalline silicon emitter region.

In one embodiment, the solar cell further includes a P/N junction between the first polycrystalline silicon emitter region and the second polycrystalline silicon emitter region.

In one embodiment, the impurity of the first conductivity type in the first polycrystalline silicon emitter region is an N-type impurity, and the impurity of the second conductivity type in the second polycrystalline silicon emitter region is a P-type impurity.

In one embodiment, the N-type impurity is phosphorous and the total concentration of the impurity of the first conductivity type in the first polycrystalline silicon emitter region is approximately 1E20 atoms/cm³, and the P-type impurity is boron and the total concentration of the impurity of the second conductivity type in the second polycrystalline silicon emitter region is approximately 1E18 atoms/cm³.

In one embodiment, the first polycrystalline silicon emitter region further includes the impurity of the second conductivity type.

In one embodiment, the total concentration of the impurity of the first conductivity type in the first polycrystalline silicon emitter region is approximately two orders of magnitude greater than the total concentration of the impurity of the second conductivity type in the second polycrystalline silicon emitter region and in the first polycrystalline silicon emitter region.

In one embodiment, the solar cell further includes a first conductive contact structure electrically connected to the first polycrystalline silicon emitter region, and a second conductive contact structure electrically connected to the second polycrystalline silicon emitter region.

In an embodiment, a method of fabricating a solar cell includes forming a thin dielectric layer on a portion of a back surface of a substrate, the substrate having a light-receiving surface opposite the back surface. The method also includes forming a first polycrystalline silicon emitter region on a first portion of the thin dielectric layer and doped with an impurity of a first conductivity type. The method also includes forming a second polycrystalline silicon emitter region on a second portion of the thin dielectric layer proximate to the first polycrystalline silicon emitter region, the second polycrystalline silicon emitter region doped with an impurity of a second, opposite, conductivity type, wherein a total concentration of the impurity of the first conductivity type in the first polycrystalline silicon emitter region is at least an order of magnitude greater than a total concentration of the impurity of the second conductivity type in the second polycrystalline silicon emitter region.

In an embodiment, a method of fabricating alternating N-type and P-type emitter regions of a solar cell includes forming a boron-containing silicon layer above a portion of a substrate by an in situ deposition process. The method also includes implanting first regions, but not second regions, of the boron-containing silicon layer with phosphorous ions to provide phosphorous-implanted regions of the boron-containing silicon layer. The method also includes heating to provide N-type polycrystalline silicon emitters in the first regions and to provide P-type polycrystalline silicon emitters in the second regions. The method also includes forming a plurality of conductive contact structures, each of the N-type polycrystalline silicon emitters and the P-type polycrystalline silicon emitters electrically connected to one of the plurality of conductive contact structures.

In one embodiment, forming the boron-containing silicon layer includes forming a boron-containing amorphous silicon layer, and the heating includes crystallizing the boron-containing amorphous silicon layer.

In one embodiment, forming the boron-containing silicon layer includes forming a boron-doped polycrystalline silicon layer, and the heating includes activating the phosphorous ions of the phosphorous-implanted regions to form phosphorous-doped regions.

In one embodiment, forming the boron-doped polycrystalline silicon layer includes using a plasma-enhanced chemical vapor deposition (PECVD) process.

In one embodiment, implanting the boron-containing silicon layer with phosphorous ions includes implanting through a shadow mask.

In one embodiment, implanting through the shadow mask includes implanting through a graphite shadow mask positioned off of, but in close proximity to, the boron-containing silicon layer.

In one embodiment, implanting through the shadow mask includes implanting through a silicon shadow mask positioned on the boron-containing silicon layer.

In one embodiment, the heating includes forming a P/N junction between adjacent ones of the N-type polycrystalline silicon emitters and P-type polycrystalline silicon emitters.

In one embodiment, the heating provides the N-type polycrystalline silicon emitters including a total phosphorous dopant concentration of at least an order of magnitude greater than a total boron dopant concentration of the P-type polycrystalline silicon emitters.

In one embodiment, forming the boron-containing silicon layer includes forming on a portion of a thin oxide layer formed on the substrate.

## Claims

1. A solar cell, comprising:
a substrate (100) having a light-receiving surface (124) and a back surface;
a thin dielectric layer (102) disposed on a portion of the back surface of the substrate;
a boron-containing silicon layer (104) formed on the thin dielectric layer (102);
a first polycrystalline silicon doped region (112) formed in a first portion of the boron-containing silicon layer (104) and doped with phosphorous impurity; and
a second polycrystalline silicon doped region (114) formed in a second portion of the boron-containing silicon layer (104) proximate to the first polycrystalline silicon doped region (112), the second polycrystalline silicon doped region (114) doped with boron impurity,
wherein a P/N junction (116) is formed between the first polycrystalline silicon doped region (112) and the second polycrystalline silicon doped region (114), and
wherein the total concentration of the phosphorous impurity in the first polycrystalline silicon doped region (112) is 1E20 atoms/cm³, and wherein the total concentration of the boron impurity in the second polycrystalline silicon doped region (114) is 1E18 atoms/cm³.

2. The solar cell of claim 1, further comprising:
a first conductive contact structure (120) electrically connected to the first polycrystalline silicon doped region (112); and
a second conductive contact structure (122) electrically connected to the second polycrystalline silicon doped region (114).

3. A method of fabricating a solar cell, the method comprising:
forming a thin dielectric layer (102) on a portion of a back surface of a substrate (100), the substrate (100) having a light-receiving surface (124) opposite the back surface;
forming a boron-containing silicon layer (104) on the thin dielectric layer (102);
forming a first polycrystalline silicon doped region (112) in a first portion of the boron-containing silicon layer (104) and doped with a phosphorous impurity; and
forming a second polycrystalline silicon doped region (114) in a second portion of the boron-containing silicon layer (104) proximate to the first polycrystalline silicon doped region (112), the second polycrystalline silicon doped region (114) doped with a boron impurity,
wherein a P/N junction (116) is formed between the first polycrystalline silicon doped region (112) and the second polycrystalline silicon doped region (114), and
wherein the total concentration of the phosphorous impurity in the first polycrystalline silicon doped region (112) is 1E20 atoms/cm³, and wherein the total concentration of the boron impurity in the second polycrystalline silicon doped region (114) is 1E18 atoms/cm³.

4. A method of fabricating alternating N-type and P-type doped regions of a solar cell, the method comprising:
forming a boron-containing silicon layer (104) above a portion of a substrate (100) by an in situ deposition process;
implanting first regions (106), but not second regions (108), of the boron-containing silicon layer (104) with phosphorous ions to provide phosphorous-implanted regions of the boron-containing silicon layer (104);
heating to provide N-type polycrystalline silicon doped regions (112) in the first regions and to provide P-type polycrystalline silicon doped regions (114) in the second regions; and
forming a plurality of conductive contact structures (120, 122), each of the N-type polycrystalline silicon doped regions (112) and the P-type polycrystalline silicon doped regions (114) electrically connected to one of the plurality of conductive contact structures (120, 122),
wherein a P/N junction (116) is formed between the N-type polycrystalline silicon doped region (112) and the P-type polycrystalline silicon doped region (114), and
wherein the total concentration of phosphorous in the first polycrystalline silicon doped region (112) is 1E20 atoms/cm³, and wherein the total concentration of boron in the second polycrystalline silicon doped region (114) is 1E18 atoms/cm³.

5. The method of claim 4, wherein forming the boron-containing silicon layer (104) comprises forming a boron-containing amorphous silicon layer, and wherein the heating comprises crystallizing the boron-containing amorphous silicon layer.

6. The method of claim 4, wherein forming the boron-containing silicon layer (104) comprises forming a boron-doped polycrystalline silicon layer, and wherein the heating comprises activating the phosphorous ions of the phosphorous-implanted regions to form phosphorous-doped regions.

7. The method of claim 4, wherein forming the boron-containing silicon layer (104) comprises forming on a portion of a thir oxide layer formed on the substrate (100).

8. The method of claim 6, wherein forming the boron-doped polycrystalline silicon layer (104) comprises using a plasma-enhanced chemical vapor deposition (PECVD) process.

9. The method of claim 4, wherein implanting the boron-containing silicon layer with phosphorous ions comprises implanting through a shadow mask.

10. The method of claim 9, wherein:
implanting through the shadow mask comprises implanting through a graphite shadow mask positioned off of, but in close proximity to, the boron-containing silicon layer (104), or
implanting through the shadow mask comprises implanting through a silicon shadow mask positioned on the boron-containing silicon layer (104).

11. The method of claim 4, wherein the heating comprises forming a P/N junction (116) between adjacent ones of the N-type polycrystalline silicon doped regions (112) and P-type polycrystalline silicon doped regions (114).

## Patentansprüche

1. Solarzelle, umfassend:
ein Substrat (100), das eine Lichtempfangsfläche (124) und einer Rückfläche aufweist;
eine dünne dielektrische Schicht (102), die auf einem Abschnitt der Rückseite des Substrats angeordnet ist;
eine borhaltige Siliziumschicht (104), die auf der dünnen dielektrischen Schicht (102) ausgebildet ist;
eine erste mit polykristallinem Silizium dotierte Region (112), die in einem ersten Abschnitt der borhaltigen Siliziumschicht (104) ausgebildet und mit Phosphorverunreinigung dotiert ist; und
eine zweite mit polykristallinem Silizium dotierte Region (114), die in einem zweiten Abschnitt der borhaltigen Siliziumschicht (104) nahe der ersten mit polykristallinem Silizium dotierten Region (112) ausgebildet ist, wobei die zweite mit polykristallinem Silizium dotierte Region (114) mit Borverunreinigung dotiert ist,
wobei ein p-n-Übergang (116) zwischen der ersten mit polykristallinem Silizium dotierten Region (112) und der zweiten mit polykristallinem Silizium dotierten Region (114) ausgebildet ist und
wobei die Gesamtkonzentration der Phosphorverunreinigung in der ersten mit polykristallinem Silizium dotierten Region (112) 1E20 Atome/cm³ beträgt und wobei die Gesamtkonzentration der Borverunreinigung in der zweiten mit polykristallinem Silizium dotierten Region (114) 1E18 Atome/cm³ beträgt.

2. Solarzelle nach Anspruch 1, ferner umfassend:
eine erste leitfähige Kontaktstruktur (120), die elektrisch mit der ersten mit polykristallinem Silizium dotierten Region (112) verbunden ist; und
eine zweite leitfähige Kontaktstruktur (122), die elektrisch mit der zweiten mit polykristallinem Silizium dotierten Region (114) verbunden ist.

3. Verfahren zum Herstellen einer Solarzelle, wobei das Verfahren umfasst:
Bilden einer dünnen dielektrischen Schicht (102) auf einem Abschnitt einer Rückfläche eines Substrats (100), wobei das Substrat (100) eine Lichtempfangsfläche (124) gegenüber der Rückfläche aufweist;
Bilden einer borhaltigen Siliziumschicht (104) auf der dünnen dielektrischen Schicht (102);
Bilden einer ersten mit polykristallinem Silizium dotierten Region (112) in einem ersten Abschnitt der borhaltigen und mit einer Phosphorverunreinigung dotierten Siliziumschicht (104); und
Bilden einer zweiten mit polykristallinem Silizium dotierten Region (114) in einem zweiten Abschnitt der borhaltigen Siliziumschicht (104) nahe der ersten mit polykristallinem Silizium dotierten Region (112), wobei die zweite mit polykristallinem Silizium dotierte Region (114) mit einer Borverunreinigung dotiert ist,
wobei ein p-n-Übergang (116) zwischen der ersten mit polykristallinem Silizium dotierten Region (112) und der zweiten mit polykristallinem Silizium dotierten Region (114) ausgebildet ist und
wobei die Gesamtkonzentration der Phosphorverunreinigung in der ersten mit polykristallinem Silizium dotierten Region (112) 1E20 Atome/cm³ beträgt und wobei die Gesamtkonzentration der Borverunreinigung in der zweiten mit polykristallinem Silizium dotierten Region (114) 1E18 Atome/cm³ beträgt.

4. Verfahren zum Herstellen abwechselnder p- und n-dotierter Regionen einer Solarzelle, wobei das Verfahren umfasst:
Bilden einer borhaltigen Siliziumschicht (104) über einem Abschnitt eines Substrats (100) durch einen in-situ-Abscheidungsprozess;
Implantieren erster Regionen (106), jedoch nicht zweiter Regionen (108), der borhaltigen Siliziumschicht (104) mit Phosphorionen, um phosphorimplantierte Regionen der borhaltigen Siliziumschicht (104) bereitzustellen;
Erwärmen, um mit polykristallinem Silizium n-dotierte Regionen (112) in den ersten Regionen bereitzustellen und mit polykristallinem Silizium p-dotierte Regionen (114) in den zweiten Regionen bereitzustellen; und
Bilden einer Vielzahl von leitfähigen Kontaktstrukturen (120, 122), wobei jede mit polykristallinem Silizium n-dotierten Regionen (112) und der mit polykristallinem Silizium p-dotierten Regionen (114) elektrisch mit einer der Vielzahl von leitfähigen Kontaktstrukturen (120, 122) verbunden ist,
wobei ein p-n-Übergang (116) zwischen der mit polykristallinem Silizium n-dotierten Region (112) und der mit polykristallinem Silizium p-dotierten Region (114) ausgebildet ist, und
wobei die Gesamtkonzentration von Phosphor in der ersten mit polykristallinem Silizium dotierten Region (112) 1E20 Atome/cm³ beträgt und wobei die Gesamtkonzentration von Bor in der zweiten mit polykristallinem Silizium dotierten Region (114) 1E18 Atome/cm³ beträgt.

5. Verfahren nach Anspruch 4, wobei
das Bilden der borhaltigen Siliziumschicht (104) ein Bilden einer borhaltigen amorphen Siliziumschicht umfasst und wobei das Erwärmen ein Kristallisieren der borhaltigen amorphen Siliziumschicht umfasst.

6. Verfahren nach Anspruch 4, wobei
das Bilden der borhaltigen Siliziumschicht (104) ein Bilden einer bordotierten polykristallinen Siliziumschicht umfasst und wobei das Erwärmen ein Aktivieren der Phosphorionen der phosphorimplantierten Regionen umfasst, um phosphordotierte Regionen zu bilden.

7. Verfahren nach Anspruch 4, wobei
das Bilden der borhaltigen Siliziumschicht (104) das Bilden auf einem Abschnitt einer dünnen Oxidschicht umfasst, die auf dem Substrat (100) gebildet ist.

8. Verfahren nach Anspruch 6,
wobei das Bilden der bordotierten polykristallinen Siliziumschicht (104) ein Verwenden eines plasmaunterstützten chemischen Gasphasenabscheidungsprozesses (plasma-enhanced chemical vapor deposition, PECVD) umfasst.

9. Verfahren nach Anspruch 4,
wobei das Implantieren der borhaltigen Siliziumschicht mit Phosphorionen ein Implantieren durch eine Lochmaske umfasst.

10. Verfahren nach Anspruch 9, wobei:
das Implantieren durch die Lochmaske das Implantieren durch eine Graphit-Lochmaske umfasst, die außerhalb, aber in unmittelbarer Nähe der borhaltigen Siliziumschicht (104) positioniert ist, oder
das Implantieren durch die Lochmaske das Implantieren durch eine Silizium-Lochmaske umfasst, die auf der borhaltigen Siliziumschicht (104) positioniert ist.

11. Verfahren nach Anspruch 4,
wobei das Erwärmen ein Bilden eines p-n-Übergangs (116) zwischen benachbarten der mit polykristallinem Silizium n-dotierten Regionen (112) und mit polykristallinen Silizium p-dotierten Regionen (114) umfasst.

## Revendications

1. Cellule solaire, comprenant :
un substrat (100) comportant une surface réceptrice de lumière (124) et une surface arrière ;
une mince couche diélectrique (102) disposée sur une partie de la surface arrière du substrat ;
une couche de silicium (104) contenant du bore formée sur la mince couche diélectrique (102) ;
une première zone (112) dopée au silicium polycristallin formée dans une première partie de la couche de silicium (104) contenant du bore et dopée avec une impureté phosphorée ; et
une seconde zone (114) dopée au silicium polycristallin formée dans une seconde partie de la couche de silicium (104) contenant du bore à proximité de la première zone (112) dopée au silicium polycristallin, la seconde zone (114) dopée au silicium polycristallin étant dopée avec une impureté de bore,
dans laquelle une jonction P/N (116) est formée entre la première zone (112) dopée au silicium polycristallin et la seconde zone (114) dopée au silicium polycristallin et
dans laquelle la concentration totale de l'impureté phosphorée dans la première zone (112) dopée au silicium polycristallin est de 1E20 atomes/cm³ et dans laquelle la concentration totale de l'impureté de bore dans la seconde zone (114) dopée au silicium polycristallin est de 1E18 atomes/cm³.

2. Cellule solaire selon la revendication 1, comprenant en outre :
une première structure de contact (120) conductrice connectée électriquement à la première zone (112) dopée au silicium polycristallin ; et
une seconde structure de contact (122) conductrice connectée électriquement à la seconde zone (114) dopée au silicium polycristallin.

3. Procédé de fabrication d'une cellule solaire, le procédé comprenant :
la formation d'une mince couche diélectrique (102) sur une partie d'une surface arrière d'un substrat (100), le substrat (100) comportant une surface réceptrice de lumière (124) opposée à la surface arrière ;
la formation d'une couche de silicium (104) contenant du bore sur la mince couche diélectrique (102) ;
la formation d'une première zone (112) dopée au silicium polycristallin dans une première partie de la couche de silicium (104) contenant du bore et dopée avec une impureté phosphorée ; et
la formation d'une seconde zone (114) dopée au silicium polycristallin dans une seconde partie de la couche de silicium (104) contenant du bore à proximité de la première zone (112) dopée au silicium polycristallin, la seconde zone (114) dopée au silicium polycristallin étant dopée avec une impureté de bore,
dans laquelle une jonction P/N (116) est formée entre la première zone (112) dopée au silicium polycristallin et la seconde zone (114) dopée au silicium polycristallin et
dans laquelle la concentration totale de l'impureté phosphorée dans la première zone (112) dopée au silicium polycristallin est de 1E20 atomes/cm³ et dans laquelle la concentration totale de l'impureté de bore dans la seconde zone (114) dopée au silicium polycristallin est de 1E18 atomes/cm³.

4. Procédé de fabrication de zones dopées de type N et de type P alternées d'une cellule solaire, le procédé comprenant :
la formation d'une couche de silicium (104) contenant du bore au-dessus d'une partie d'un substrat (100) selon un procédé de dépôt in situ ;
l'implantation des premières zones (106), mais pas des secondes zones (108), de la couche de silicium (104) contenant du bore avec des ions phosphore pour fournir des zones implantées de phosphore de la couche de silicium (104) contenant du bore ;
le chauffage pour fournir des zones (112) dopées au silicium polycristallin de type N dans les premières zones et pour fournir des zones (114) dopées au silicium polycristallin de type P dans les secondes zones ; et
la formation d'une pluralité de structures de contact (120, 122) conductrices, chacune des zones (112) dopées au silicium polycristallin de type N et des zones (114) dopées au silicium polycristallin de type P étant connectée électriquement à l'une de la pluralité de structures de contact (120, 122) conductrices,
dans lequel une jonction P/N (116) est formée entre la zone (112) dopée au silicium polycristallin de type N et la zone (114) dopée au silicium polycristallin de type P et
dans lequel la concentration totale de phosphore dans la première zone (112) dopée au silicium polycristallin est de 1E20 atomes/cm³ et dans lequel la concentration totale de bore dans la seconde zone (114) dopée au silicium polycristallin est de 1E18 atomes/cm³.

5. Procédé selon la revendication 4, dans lequel
la formation de la couche de silicium (104) contenant du bore comprend la formation d'une couche de silicium amorphe contenant du bore et dans lequel le chauffage comprend la cristallisation de la couche de silicium amorphe contenant du bore.

6. Procédé selon la revendication 4, dans lequel
la formation de la couche de silicium (104) contenant du bore comprend la formation d'une couche de silicium polycristallin dopée au bore et dans lequel le chauffage comprend l'activation des ions phosphore des zones implantées au phosphore pour former des zones dopées au phosphore.

7. Procédé selon la revendication 4, dans lequel
la formation de la couche de silicium (104) contenant du bore comprend la formation sur une partie d'une couche d'oxyde mince formée sur le substrat (100).

8. Procédé selon la revendication 6,
dans lequel la formation de la couche de silicium polycristallin (104) dopée au bore comprend l'utilisation d'un procédé de dépôt chimique en phase vapeur amélioré au plasma (PECVD).

9. Procédé selon la revendication 4,
dans lequel l'implantation de la couche de silicium contenant du bore avec des ions phosphore comprend l'implantation à travers un masque perforé.

10. Procédé selon la revendication 9, dans lequel :
l'implantation à travers le masque perforé comprend l'implantation à travers un masque perforé en graphite positionné hors, mais à proximité immédiate, de la couche de silicium (104) contenant du bore ou
l'implantation à travers le masque perforé comprend l'implantation à travers un masque perforé en silicium positionné sur la couche de silicium (104) contenant du bore.

11. Procédé selon la revendication 4,
dans lequel le chauffage comprend la formation d'une jonction P/N (116) entre des zones adjacentes des zones (112) dopées au silicium polycristallin de type N et des zones (114) dopées au silicium polycristallin de type P.
